# FASCICULE DE BREVET EUROPEEN

(11) **EP 1 950 885 B1**
(45) Date de publication et mention de la délivrance du brevet: **02.06.2010**
(21) Numéro de dépôt: 08100706.4
(22) Date de dépôt: 21.01.2008
(51) Int. Cl.: H03K 17/20, H03K 17/687, H03K 17/0412

(54) **Dispositif de commande d'un interrupteur électronique de puissance et variateur comprenant un tel dispositif.**
Steuervorrichtung eines elektronischen Leistungstrenners und eine solche Vorrichtung umfassender Stromrichter
Control device of an electronic power switch and infinitely-variable speed transmission comprising such a device.

(30) Priorité: 23.01.2007 FR 0752840
(43) Date de publication de la demande: 30.07.2008
(73) Titulaire: Schneider Toshiba Inverter Europe SAS, 27120 Pacy sur Eure (FR)
(72) Inventeur: Arpilliere, Michel, 78300 POISSY (FR); Baudesson, Philippe, 27220 LA BOISSIERE (FR); Boulharts, Hocine, 78510 TRIEL SUR SEINE (FR); Loizelet, Philippe, 27120 LE PLESSIS HEBERT (FR)
(74) Mandataire: Dufresne, Thierry

(56) Documents cités:
- WO-A-2007/137569
- US-A1- 2003 179 021
- US-A1- 2004 004 404
- DOMES D, WENER R, HOFMANN W, DOMES K, KRAUSS S: "A New, Universal and Fast Switching Gate-Drive-Concept for SiC-JFETs based on Current Source Principle" 2006 IEEE POWER ELECTRONICS SPECIALISTS CONFERENCE 18-22 JUNE 2006 JEJU, SOUTH KOREA, 22 juin 2006 (2006-06-22), pages 2640-2645, XP002450191 IEEE Piscataway, NJ, USA ISBN: 1-4244-9717-7
- "MEMs for Improved Power Management" IP.COM JOURNAL, IP.COM INC., WEST HENRIETTA, NY, US, 22 février 2005 (2005-02-22), XP013023381 ISSN: 1533-0001

## Description

La présente invention se rapporte à un dispositif de commande d'un interrupteur électronique de puissance de type transistor JFET (Junction Field Effect Transistor ou Transistor à Effet de Champ à Jonction) réalisé par exemple en carbure de silicium (SiC ou Silicon Carbide). L'invention se propose d'utiliser de tels transistors JFET du type normalement fermé (ou "normally ON") pour la commutation d'importants courants de puissance et en particulier comme interrupteurs de puissance dans un étage onduleur d'un variateur de vitesse.

Un transistor JFET est un interrupteur électronique connu qui comporte une Grille de commande dont la fonction est d'autoriser ou non le passage d'un courant entre un Drain et une Source. Un tel transistor est dit du type normalement fermé (ou Normally ON) si la tension V_{DS} entre le Drain et la Source est nulle lorsque la tension V_{GS} entre la Grille et la Source est nulle. Cela signifie que le chemin Drain - Source est passant ou conducteur en l'absence de tension de commande V_{GS} entre Grille et Source. Inversement un transistor JFET est dit du type normalement ouvert (ou normally OFF) si le chemin Drain - Source n'est pas conducteur en l'absence de tension V_{GS} entre Grille et Source.

Il s'avère qu'un interrupteur électronique JFET de type normalement fermé offre de bien meilleures performances que d'autres types d'interrupteurs électroniques de puissance commandés en tension, tels que des MOSFET, des IGBT ou même des JFET de type normalement ouvert. En effet, un tel interrupteur présente notamment les avantages d'être plus rapide à commuter, de générer moins de pertes à l'état passant, d'avoir une meilleure tenue en température, d'avoir une taille plus petite et de coûter moins cher.

Néanmoins, tout interrupteur électronique du type normalement fermé présente l'inconvénient d'être à l'état passant (ou fermé) en l'absence de tension de commande sur sa Grille (Gate). Cette caractéristique n'est pas sécurisante pour la commande de courants importants puisque cet interrupteur laisse passer le courant entre Drain et Source en l'absence de commande sur la Grille. Il en résulte évidemment des risques potentiels importants pour la sécurité des biens et des personnes.

De façon usuelle, un variateur de vitesse de type convertisseur de fréquence comporte un étage redresseur chargé de redresser une tension provenant d'une source extérieure d'alimentation électrique alternative (par exemple un réseau électrique triphasé 380Vac) pour fournir une tension continue sur un bus continu (par exemple de l'ordre de 400 à 800Vcc ou plus suivant les conditions d'utilisation). Un ou plusieurs condensateurs de bus de forte capacité sont habituellement utilisés pour maintenir constante la tension du bus continu.

Le variateur de vitesse comporte ensuite un étage onduleur chargé de commander un moteur électrique avec une tension d'amplitude et de fréquence variables, à partir de ce bus continu. Pour cela, l'étage onduleur est doté de deux interrupteurs électroniques de puissance par phase. Chaque interrupteur est commandé par un circuit de commande alimenté par une alimentation à découpage (alimentation de type SMPS : Switched Mode Power Supply) du variateur de vitesse.

Ainsi, si l'on veut utiliser des interrupteurs électroniques du type normalement fermé dans l'étage onduleur d'un variateur de vitesse, plusieurs risques peuvent alors apparaître :
- A la mise sous tension du variateur, il faut s'assurer que les circuits de commande des interrupteurs électroniques sont correctement alimentés, pour pouvoir ouvrir ces interrupteurs avant l'apparition de la tension sur le bus continu du variateur,
- A la mise hors tension, il faut s'assurer du maintien de l'ouverture des interrupteurs électroniques, tant que le ou les condensateurs de bus ne sont pas déchargés, par exemple dans des résistances d'équilibrage, sachant que la décharge de ces condensateurs peut parfois durer jusqu'à plusieurs minutes,
- Lors de l'apparition d'un défaut, il faut également s'assurer du maintien de l'ouverture des interrupteurs tant que le ou les condensateurs du bus continu ne sont pas déchargés. Un tel défaut peut provenir notamment d'un court-circuit dans le circuit de commande, d'une perte de l'alimentation du circuit de commande, etc...

Pour éviter ces risques, il existe déjà une solution dans laquelle chaque transistor JFET de type normalement fermé est monté en série avec un autre composant auxiliaire de type normalement ouvert, tel que par exemple un transistor CASCODE. Cette solution nécessite cependant l'utilisation de deux transistors en série pour chaque interrupteur de puissance, ce qui entraîne notamment une augmentation des coûts et une augmentation des pertes par conduction.

Un interrupteur JFET de type normalement fermé est connu de WO 2007/137569.

Le but de l'invention est donc de proposer l'utilisation de transistors JFET de type normalement fermé comme interrupteurs de puissance dans un étage onduleur d'un variateur de vitesse, grâce à un dispositif de commande capable d'éviter les inconvénients évoqués ci-dessus, à savoir proposer une solution simple qui permette d'éviter les risques lors des mises sous/hors tension et lors de défauts.

Pour cela, l'invention décrit un dispositif de commande d'un interrupteur électronique de puissance de type JFET de type normalement fermé selon la revendication 1.

Selon une caractéristique, l'organe de commutation de protection comporte un commutateur électromagnétique doté d'un contact mobile entre deux positions sous l'action d'une bobine de commande du circuit auxiliaire de commande, ledit contact mobile étant commutable entre une première position dans laquelle la grille de l'interrupteur JFET est reliée au circuit principal de commande de grille et une seconde position dans laquelle la grille de l'interrupteur JFET est reliée à la borne négative de la source auxiliaire d'énergie. En l'absence d'alimentation de la bobine de commande, le contact mobile est maintenu dans la seconde position.

Selon une autre caractéristique, l'organe de commutation de protection comprend un premier commutateur électronique qui est placé entre la grille de l'interrupteur JFET et la borne négative de la source auxiliaire d'énergie, et qui est piloté par le circuit auxiliaire de commande entre un premier état non-passant dans lequel la grille de l'interrupteur JFET n'est pas reliée à la borne négative de la source auxiliaire d'énergie et un second état passant dans lequel la grille de l'interrupteur JFET est reliée à la borne négative de la source auxiliaire d'énergie.

D'autres caractéristiques et avantages vont apparaître dans la description détaillée qui suit en se référant à un mode de réalisation donné à titre d'exemple et représenté par les dessins annexés sur lesquels :
- la figure 1 montre une architecture simplifiée classique d'un variateur de vitesse utilisant plusieurs interrupteurs de puissance JFET,
- la figure 2 décrit un dispositif de commande connu d'un interrupteur de puissance JFET de type normalement fermé ou normally ON,
- la figure 3 représente un premier mode de réalisation d'un dispositif de commande d'un interrupteur de puissance JFET selon l'invention,
- la figure 4 détaille un exemple d'un circuit auxiliaire de commande du commutateur électromagnétique selon le premier mode de réalisation,
- la figure 5 donne une variante du premier mode de réalisation,
- la figure 6 montre un second mode de réalisation d'un dispositif de commande d'un interrupteur de puissance JFET selon l'invention,
- les figures 7 & 8 donnent des variantes du second mode de réalisation.

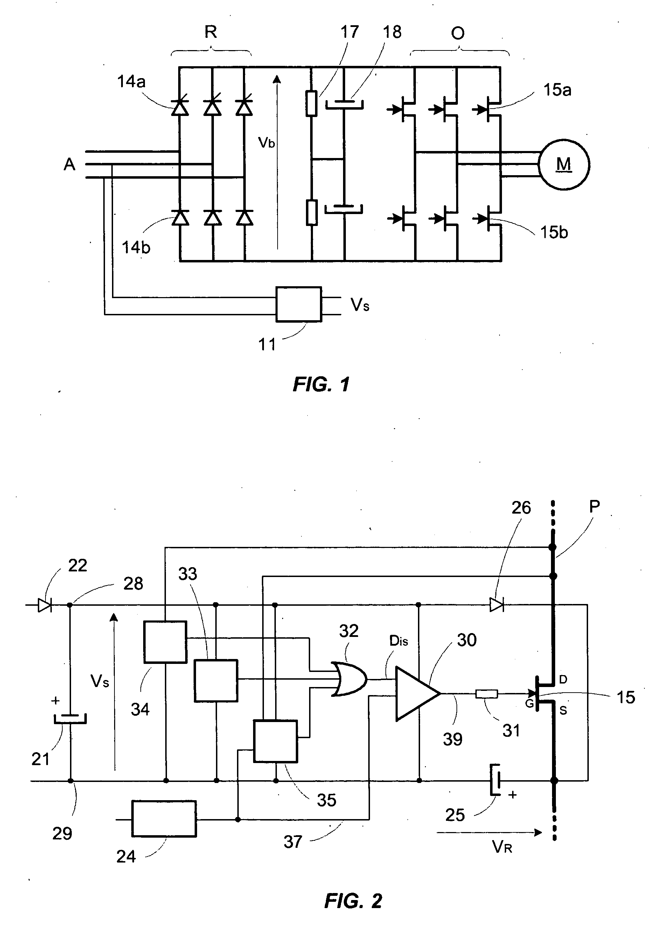

En référence à la figure 1, un variateur de vitesse comporte un étage redresseur R chargé de redresser une tension triphasée alternative provenant d'un réseau d'alimentation extérieur A, dans le but de fournir une tension de bus continu Vb. Pour cela, l'étage redresseur R comporte deux composants électroniques de puissance 14a,14b par phase. Ces composants 14a,14b sont par exemple des diodes et/ou des thyristors. L'exemple de la figure 1 présente un thyristor 14a couplé avec une diode 14b pour chaque phase du réseau A. Pour maintenir constante la tension Vb du bus continu, le variateur montré en figure 1 comporte deux condensateurs de bus 18 couplés à deux résistances d'équilibrage 17 qui permettent d'équilibrer la tension entre ces deux condensateurs.

Le variateur de vitesse comporte ensuite un étage onduleur O permettant, à partir du bus continu Vb, de commander un moteur électrique M avec une tension d'amplitude et de fréquence variables, au moyen d'une commande par Modulation à Largeur d'Impulsions (MLI ou PWM). Pour cela, l'étage onduleur est doté de deux interrupteurs électroniques de puissance 15a,15b par phase. Chaque interrupteur 15a,15b est un transistor JFET (à Effet de Champ à Jonction) de type normalement fermé (c'est-à-dire à l'état passant en l'absence de tension sur la Grille du transistor) qui est réalisé en carbure de silicium (SiC). D'autres matériaux que le carbure de silicium pourraient aussi être utilisés : ainsi, on pourrait utiliser tout matériau à grande énergie de bande interdite (appelé également matériau à grand gap ou "wide-band gap material"), c'est-à-dire présentant une faible résistance à l'état passant R_{dson} et capable de supporter des tensions importantes (supérieures à 1000 V), comme par exemple du nitrure de gallium (GaN).

Ces dispositifs de commande sont alimentés par une alimentation à découpage 11 (SMPS : Switched Mode Power Supply) du variateur de vitesse, qui fournit une tension continue Vs à partir du réseau d'alimentation A. La tension Vs est notamment utilisée pour alimenter l'unité de commande du variateur (non représentée sur la figure 1), les dispositifs de commande des transistors JFET 15a,15b, ainsi que les dispositifs de commande des thyristors 14a de l'étage redresseur.

A cause de l'utilisation d'interrupteurs de puissance 15a,15b de type normalement fermé, il faut évidemment s'assurer que les dispositifs de commande de ces interrupteurs 15a,15b sont alimentés correctement avant l'apparition de la tension de bus Vb, pour éviter un court-circuit dans l'étage onduleur O du variateur et/ou des courants intempestifs dans le moteur M. Il faut donc s'assurer que l'alimentation à découpage 11 fournit la tension Vs avant l'apparition de la tension de bus Vb.

Une première solution décrite en figure 1 consiste à alimenter l'alimentation à découpage 11 directement à partir du réseau alternatif extérieur A et à utiliser, dans l'étage redresseur R, des thyristors 14a dont les dispositifs de commande sont alimentés par l'alimentation à découpage 11. Ainsi, tant que la tension Vs n'est pas présente, les thyristors 14a ne sont pas commandés et la tension de bus Vb n'apparaît pas.

Une autre solution consiste par exemple à alimenter l'alimentation à découpage 11 directement à partir du réseau alternatif extérieur A, en amont d'un contacteur de ligne (non représenté) présent à l'entrée du variateur. La bobine de ce contacteur de ligne est commandée à partir de la tension Vs. Ainsi, tant que la tension Vs n'est pas présente, le contacteur de ligne est ouvert. L'étage redresseur R du variateur n'est alors pas alimenté et la tension de bus Vb n'apparaît pas. Dans cette solution, l'étage redresseur R peut ne comporter que des diodes 14a,14b.

La figure 2 montre un dispositif de commande existant d'un interrupteur électronique de puissance 15 de type transistor JFET normalement fermé, réalisé par exemple en SiC. Un tel transistor JFET 15 est commandé en appliquant une tension négative V_{GS} entre la Grille G et la source S. En l'absence de tension V_{GS} entre Grille G et Source S ou en présence d'une tension V_{GS} positive, le transistor 15 est passant entre le Drain D et la Source S, c'est-à-dire que la tension V_{DS} est nulle. Pour bloquer le transistor 15 (c'est-à-dire tension V_{DS} maximale), il faut appliquer une tension V_{GS} négative suffisante, par exemple de l'ordre de -15 Volts.

Le dispositif de commande comporte un circuit principal de commande de grille 30 (appelé également Gate Driver) qui est un circuit amplificateur de puissance permettant la commande de la grille G, à partir d'un signal de commande 37. De façon connue, ce circuit principal de commande de grille 30 peut être du type "Push-Pull", "Reversed Push-Pull" ou "Totem Pôle" et réalisé avec des transistors bipolaires ou des transistors MOSFET. La sortie 39 du circuit principal de commande de grille 30 est reliée à la grille G du transistor JFET 15 par l'intermédiaire d'une résistance 31. Le signal de commande 37 du transistor 15 provient par exemple de l'unité de commande 24 du variateur de vitesse.

Suivant les fonctionnalités souhaitées, le dispositif de commande de la figure 2 comporte également un ou plusieurs modules de détection de défaut 33,34,35, dont le but est de permettre le maintien du transistor 15 à l'état OFF en cas d'apparition d'un de ces défauts. Lorsque plusieurs modules de détection de défaut sont présents, les sorties de ces modules de détection 33,34,35 forment les entrées d'une porte logique OU ("OR") 32, dont la sortie fournit une entrée de désactivation (ou "Disable") D_{IS} au circuit principal de commande de grille 30. Lorsque cette entrée D_{IS} est à l'état 1, cela signifie que le circuit de commande de grille 30 doit forcer le transistor 15 à l'état OFF (quel que soit l'état du signal de commande C) et donc fournir une tension négative V_{GS} (de l'ordre de -15 V) sur la grille G.

Un premier module de détection de sous-tension 33 sert à détecter l'apparition d'une chute de la tension Vs de l'alimentation 11 en dessous d'un seuil prédéterminé. Cette chute de tension peut notamment provenir soit de la mise hors tension du variateur, soit d'un défaut ou d'un court-circuit de l'alimentation 11, de la capacité tampon 21 ou du circuit de commande de grille 30.

Un deuxième module de détection de court-circuit 35 sert à détecter l'apparition d'un court-circuit dans le transistor JFET 15. Le module de détection de court-circuit 35 compare le signal de commande 37 avec la tension réelle aux bornes du transistor JFET 15 pour détecter un éventuel court-circuit.

Un troisième module de détection de surtension 34 sert à détecter l'apparition d'une surtension aux bornes du transistor JFET 15. Cette surtension peut par exemple survenir lorsque l'on cherche à ouvrir le transistor JFET 15 alors qu'un court-circuit existe sur la ligne de puissance P du transistor JFET 15.

Le dispositif de commande est alimenté par une source principale d'énergie délivrant une tension principale Vs entre les bornes positive 28 et négative 29. Dans le cadre d'un variateur de vitesse, cette source principale d'énergie provient préférentiellement de l'alimentation à découpage 11, associée à une diode de redressement 22 et une capacité principale 21 servant de tampon d'énergie pour la tension Vs.

Le dispositif de commande comporte aussi une source auxiliaire d'énergie 25 qui est chargée à l'aide de la tension Vs au travers d'une diode de charge 26. Préférentiellement, cette source auxiliaire d'énergie est une simple capacité auxiliaire de réserve 25. La borne négative de la capacité auxiliaire 25 est reliée à la borne négative 29 de la capacité principale 21. La borne positive de la capacité auxiliaire 25 est reliée à la source S du transistor JFET 15 et à la borne positive 28 de la capacité principale 21 via la diode de charge 26. La capacité auxiliaire de réserve 25 peut être une capacité chimique, qui présente l'avantage d'être moins coûteuse, ou préférentiellement une capacité tantale ou polypropylène, qui présente l'avantage d'être plus robuste.

Cette diode de charge 26 sert à éviter que la capacité auxiliaire 25 ne se décharge dans tous les éléments placés en parallèle avec la capacité principale 21, tels que les éléments 33, 35, 30, lorsque la tension Vs est inférieure à la tension V_{R} aux bornes de la capacité auxiliaire 25. Elle est placée en aval du circuit le plus proche du transistor JFET 15 (en l'occurrences le circuit 30 sur les figures), c'est-à-dire entre la capacité auxiliaire 25 et les raccordements du circuit 30. Sa cathode est dirigée vers la borne positive de la capacité auxiliaire 25 et son anode est dirigée vers la borne positive 28. On aurait pu aussi disposer la diode de charge 26 entre les bornes négatives des capacités 21,25, sa cathode étant alors reliée à la borne négative de la capacité auxiliaire 25 et son anode reliée à la borne négative 29.

Lorsque la tension Vs apparaît, la capacité auxiliaire 25 se charge automatiquement, car la diode de charge 26 est passante tant que la tension V_{R} est inférieure à la tension Vs. Lorsque la tension Vs chute et devient inférieure à la tension V_{R}, la capacité auxiliaire 25 fournit une réserve de tension pour alimenter le circuit de commande de grille 30, dont la sortie 39 doit fournir une tension V_{GS} négative. La taille de la capacité auxiliaire 25 doit être calculée pour obtenir une tension négative V_{GS} qui soit capable de maintenir le transistor JFET 15 à l'état bloqué OFF, durant une durée T suffisante pour s'assurer que les condensateurs de bus du variateur sont bien déchargés (par exemple de l'ordre de 10 minutes). En effet, tant que les condensateurs de bus ne sont pas déchargés, il ne faut pas que le transistor JFET 15 repasse à l'état passant ON, pour des raisons de sécurité.

Or, il se trouve que tout circuit de commande de grille 30 (Gate driver) consomme de l'énergie et génère des courants de fuite qui peuvent être importants (par exemple supérieurs à 1 mA). La capacité auxiliaire 25 va donc se décharger assez rapidement dans le circuit 30. Il faut alors une très forte capacité auxiliaire 25 pour arriver à fournir la réserve d'énergie suffisante permettant de bloquer le transistor JFET 15 pendant toute la durée T. Cela entraîne donc des problèmes de faisabilité, de coût et de dimensions, en particulier pour un variateur triphasé comprenant six transistors JFET 15 distincts dans son étage onduleur.

C'est pourquoi, l'un des buts de l'invention est de concevoir un dispositif de commande permettant de minimiser les pertes lorsque la capacité auxiliaire 25 doit fournir la tension V_{GS} pour maintenir le transistor JFET 15 à l'état bloqué OFF pendant la durée T. Pour cela, l'invention propose de rajouter un organe de commutation de protection au dispositif de commande. Cet organe de commutation est commutable entre deux positions et est agencé pour que, dans l'une de ces deux positions, la borne négative de la capacité auxiliaire 25 soit reliée à la grille G du transistor 15 sans passer par le circuit de commande de grille 30, de sorte que dans cette position la capacité auxiliaire 25 alimente la grille 30 du transistor JFET 15 normalement fermé pour le maintenir à l'état OFF et la capacité auxiliaire 25 ne peut pas être déchargée par d'autres composants.

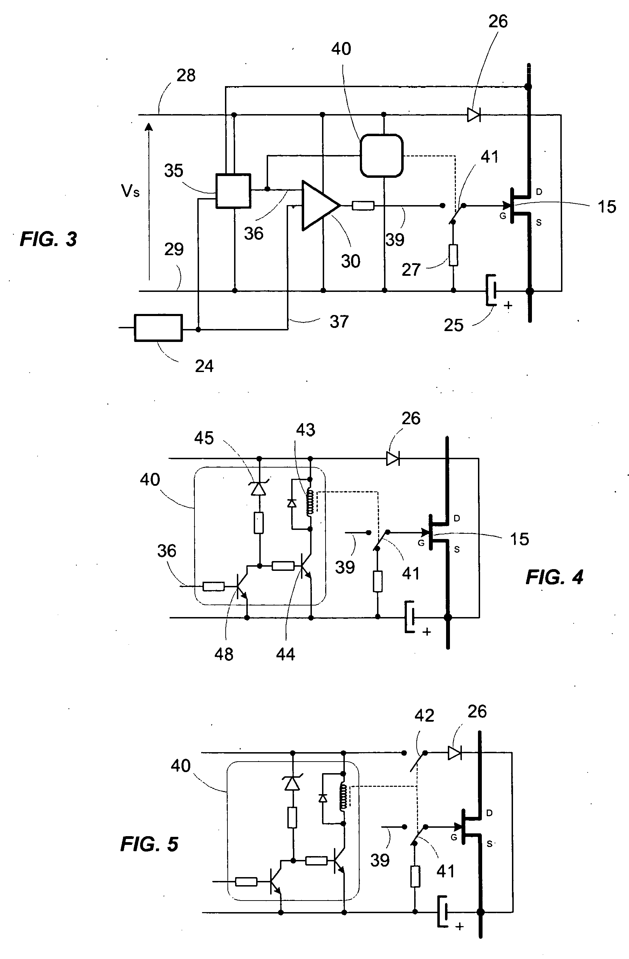

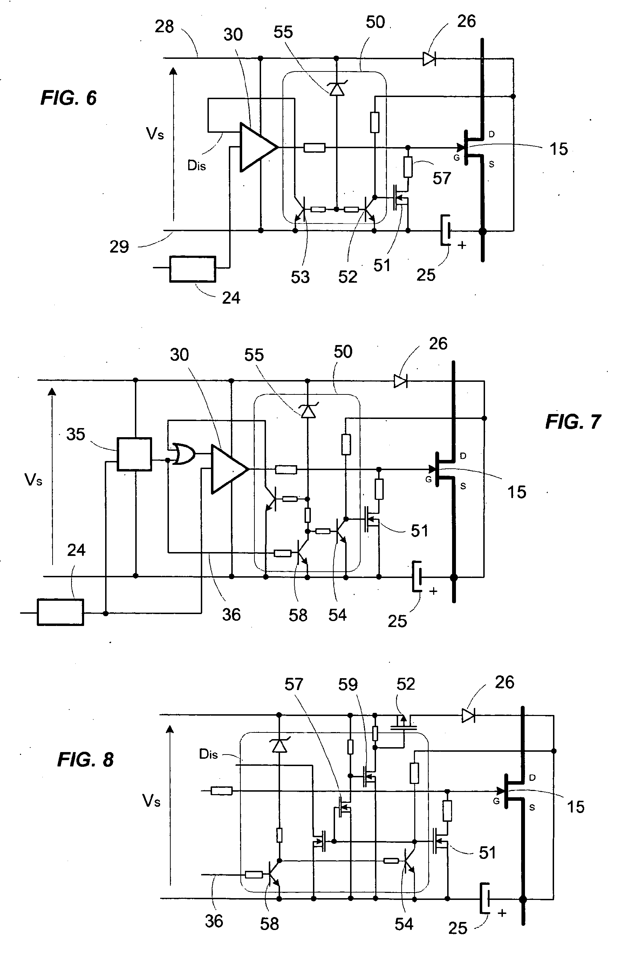

Selon un premier mode de réalisation de l'invention représenté dans les figures 3 à 5, l'organe de commutation de protection est un commutateur électromagnétique 41. Dans un second mode de réalisation représenté dans les figures 6 à 8, l'organe de commutation de protection est un commutateur électronique 51.

En référence à la figure 3, le dispositif de commande d'un interrupteur JFET est alimenté par une source principale d'énergie délivrant une tension principale Vs entre les bornes 28 et 29. Dans un variateur de vitesse, cette source principale d'énergie est préférentiellement l'alimentation à découpage 11. Le dispositif de commande comporte également une source auxiliaire d'énergie 25 qui est chargée par la tension Vs au travers d'une diode de charge 26, de façon identique au dispositif de la figure 2 décrit ci-dessus.

Comme pour la figure 2, le dispositif de commande comporte un circuit principal de commande de grille 30 (ou Gate Driver) permettant la commande de la grille G, à partir du signal de commande 37 qui provient par exemple de l'unité de commande 24 du variateur de vitesse. Dans la figure 3, un seul module de détection de défaut est présenté (en l'occurrence un module de détection de court-circuit 35 du transistor JFET), la sortie 36 de ce module de détection étant directement reliée à l'entrée D_{IS} du circuit de commande de grille 30.

La sortie 39 du circuit principal de commande de grille 30 est reliée à la grille G du transistor JFET 15 par l'intermédiaire d'une résistance 31. Contrairement à la figure 2, un organe de commutation de protection de type commutateur électromagnétique est placé entre la sortie 39 et la grille G.

Ce commutateur électromagnétique comporte un contact mobile 41 qui est commutable entre deux positions sous l'action d'un circuit auxiliaire de commande 40.

Dans la première position du contact mobile 41, le commutateur électromagnétique permet de raccorder la grille G du transistor JFET 15 à la sortie 39 du circuit de commande de grille 30. Dans la seconde position du contact mobile 41, le commutateur électromagnétique isole la grille G de la sortie 39 et raccorde la grille G à la borne négative de la capacité auxiliaire de réserve 25, via éventuellement une résistance 27. Ainsi dans cette seconde position, la borne négative de la capacité auxiliaire 25 est connectée à la grille G sans passer par le circuit de commande de grille 30. La résistance 27 est de préférence assez importante de façon à limiter la variation de courant dl/dt lors du blocage du transistor JFET 15 et donc éviter d'éventuelles surtensions.

Le commutateur électromagnétique est conçu pour qu'en l'absence d'alimentation de sa bobine de commande, le contact mobile 41 soit toujours maintenu dans la seconde position, par exemple grâce à des moyens de rappel magnétiques (aimant permanent) ou élastiques. Préférentiellement, on utilise un commutateur électromagnétique de type MEMS (Micro Electro-Magnétic Switch) dont la consommation d'énergie, l'encombrement et le temps de réponse sont très faibles et qui ne génère pas de rebond.

Un exemple d'un circuit auxiliaire de commande 40 est détaillé aux figures 4 et 5, dans lesquelles le circuit de commande de grille 30 n'est pas représenté par souci de simplification. Le circuit auxiliaire de commande 40 comprend une bobine de commande 43 qui actionne le contact mobile 41 du commutateur électromagnétique. La première extrémité de la bobine 43 est reliée à la borne positive 28. La seconde extrémité de la bobine 43 est reliée à la borne négative 29 via un transistor 44. Dans l'exemple de la figure 4, le transistor 44 est un transistor bipolaire NPN dont le Collecteur est relié à la seconde extrémité de la bobine 43 et dont l'Emetteur est relié à la borne négative 29. La Base de ce transistor bipolaire 44 est reliée à la borne positive 28 au travers d'une résistance et d'un organe de détection d'un seuil minimum de tension Vs, tel qu'une diode Zener 45. De façon équivalente, le circuit auxiliaire de commande 40 pourrait aussi être composé avec des transistors à effet de champ de type MOSFET à la place des transistors bipolaires.

En fonctionnement normal, lorsque la tension Vs est présente, la diode Zener 45 conduit, donc le transistor 44 est passant et un courant circule dans la bobine de commande 43. Le contact mobile 41 est alors maintenu dans sa première position, ce qui permet de relier la grille G à la sortie 39 du circuit de commande de grille 30. La capacité auxiliaire 25 se charge via la diode 26.

Quand la tension Vs chute et passe sous le seuil minimum de déclenchement déterminé par la diode Zener 45, celle-ci ne conduit plus et le transistor 44 devient bloquant. Aucun courant ne circulant alors dans la bobine de commande 43, le contact mobile 41 est automatiquement et rapidement rappelé dans sa seconde position (grâce aux moyens de rappel) dans laquelle la grille G est reliée à la borne négative de la capacité auxiliaire 25.

Ainsi, lorsque le contact mobile 41 du commutateur électromagnétique est dans la seconde position (comme indiqué aux figures 3 à 5), la source S du transistor JFET 15 est reliée à la borne positive de la capacité auxiliaire 25 et la grille G du transistor JFET 15 est reliée à la borne négative de la capacité auxiliaire 25 via la résistance 27. On crée donc avantageusement un circuit auxiliaire d'alimentation comprenant uniquement le transistor JFET 15, la capacité auxiliaire 25 et la résistance 27. Par ailleurs, la diode 26 empêche la capacité auxiliaire 25 de se décharger vers la capacité 21 et tout autre circuit mis en parallèle avec cette source principale, tant que la tension V_{R} est supérieure à la tension Vs.

La capacité auxiliaire 25 ne peut donc plus se décharger ailleurs que dans le transistor JFET pour fournir une tension V_{GS} négative. Or, on sait qu'un transistor JFET génère très peu de courant de fuite sur sa capacité Grille-Source.

Cette solution simple permet ainsi de minimiser énormément toutes les pertes du circuit auxiliaire, et donc d'obtenir une durée T beaucoup plus importante et/ou une taille de la capacité auxiliaire 25 plus faible. Dès que la tension Vs chute sous un seuil prédéterminé par la diode Zener 45, la grille G est isolée du circuit 30 et le circuit auxiliaire d'alimentation du transistor JFET 15 est créé. Le circuit auxiliaire de commande 40 fait ainsi office de module de détection de sous-tension de la tension Vs.

Optionnellement, il est possible de rajouter aussi une fonction de protection du circuit de commande de grille 30 lorsque le transistor JFET 15 est en court-circuit. Pour cela, le circuit auxiliaire 40 comporte en plus un second transistor 48 dont le Collecteur est relié (via une résistance) à la Base du transistor 44 et dont l'Emetteur est relié à la borne négative 29. La Base du second transistor 48 est reliée (via une résistance) à la sortie 36 du module de détection de court-circuit 35 du JFET. Ainsi, lorsque ce module 35 détecte un court-circuit, sa sortie 36 passe à l'état 1, ce qui rend le transistor 48 passant et le transistor 44 passe à l'état bloquant. Dans ce cas, la bobine 43 n'est plus alimentée et le contact mobile 41 revient sur sa seconde position. Ainsi, on isole la grille G du circuit de commande de grille 30 quand un court-circuit du transistor JFET 15 est détecté. Une autre option consisterait aussi à gérer la sortie d'un module de détection de surtension 34 dans le circuit auxiliaire 40.

La figure 5 montre une variante de ce premier mode de réalisation. Dans cette variante, le commutateur électromagnétique comporte en plus un second contact mobile 42 qui est commandé comme le premier contact mobile 41 par la même bobine de commande 43 et qui est agencé entre la borne positive 28 et la diode 26 de la façon suivante :
- En fonctionnement normal (c'est-à-dire quand un courant circule dans la bobine 43), le contact mobile 42 est dans sa première position et la borne positive 28 est reliée à la diode 26, comme dans la figure 4.
- Par contre, lorsque aucun courant ne circule dans la bobine 43, le contact mobile 42 est rappelé automatiquement sur sa seconde position, ce qui permet d'isoler la borne positive 28 de la diode 26, et ainsi de déconnecter la source auxiliaire d'énergie 25 avec la source principale d'énergie.

Grâce à ce second contact mobile, on s'affranchit ainsi des éventuels courants de fuite de la diode 26 lorsqu'elle est bloquée, ce qui rallonge d'autant la durée T pendant laquelle la capacité auxiliaire 25 peut maintenir le transistor JFET 15 à l'état OFF. On empêche également de décharger la capacité principale 21 dans la capacité auxiliaire 25 suite à un éventuel court-circuit des connexions Grille Source du transistor JFET 15 lorsque celui-ci meurt en court-circuit. On évite ainsi de propager le défaut du transistor JFET dans le circuit de commande de grille 30.

Les figures 6 à 8 montrent plusieurs exemples d'un second mode de réalisation de l'invention dans lequel l'organe de commutation de protection n'est pas un commutateur électromagnétique mais comporte un premier commutateur électronique 51. Ce commutateur électronique 51 est préférentiellement un transistor MOSFET à canal N qui présente l'avantage de générer très peu de fuite lorsqu'il est à l'état ON passant.

Dans la figure 6, le dispositif de commande de l'interrupteur JFET 15 est alimenté par une source principale d'énergie et une source auxiliaire d'énergie 25, de façon identique au dispositif de la figure 3 décrit ci-dessus.

Comme pour la figure 3, le dispositif de commande comporte un circuit principal de commande de grille 30 (ou Gate Driver) permettant la commande de la grille G, à partir du signal de commande 37 qui provient par exemple de l'unité de commande 24 du variateur de vitesse. La sortie 39 du circuit principal de commande de grille 30 est reliée à la grille G du transistor JFET 15 par l'intermédiaire d'une résistance.

La Source du transistor MOSFET 51 est reliée à la borne négative de la capacité auxiliaire 25. Le Drain du transistor MOSFET 51 est relié à la grille G du transistor JFET 15 via une résistance 57. La Grille du transistor MOSFET 51 est commandée par un signal de commande provenant du circuit auxiliaire de commande 50. Ce circuit auxiliaire de commande 50 peut être réalisé avec des transistors en technologie bipolaire, comme présenté ci-dessous, ou de manière équivalente en technologie MOSFET.

La figure 6 détaille un premier exemple du circuit auxiliaire de commande 50 remplissant la fonction de détection de sous-tension de la tension Vs. Le circuit auxiliaire de commande 50 comprend un transistor bipolaire 54 dont le Collecteur est relié à la borne positive de la capacité auxiliaire 25 via une résistance et à la Grille du transistor MOSFET 51, dont l'Emetteur est relié à la borne négative de la capacité auxiliaire 25 et dont la Base est reliée à la borne positive 28 au travers d'une résistance et d'une diode Zener 55. Le fonctionnement du circuit auxiliaire de commande 50 est le suivant :

En fonctionnement normal, lorsque la tension Vs est présente, la diode Zener 55 conduit et le transistor 54 est passant. Dans ce cas le Collecteur du transistor 54 est à 0 et le commutateur électronique 51 ne reçoit pas de signal de commande. Le commutateur électronique 51 est donc dans un premier état non-passant ou bloqué. Dans ce cas, la grille G du transistor JFET 15 est commandée uniquement par la sortie 39 du circuit de commande de grille 30, car la grille G n'est pas reliée à la borne négative de la capacité 25.

Dès que la tension Vs chute et passe sous le seuil minimum de déclenchement déterminé par la diode Zener 55, celle-ci ne conduit plus et le transistor 54 devient bloquant. Dans ce cas, le Collecteur du transistor 54 est rappelé à 1 car il est relié (via une résistance) à la borne positive de la capacité auxiliaire 25. Le commutateur électronique 51 reçoit alors un signal de commande qui le fait basculer dans un second état passant. La grille G du transistor JFET 15 est alors directement reliée à la borne négative de la capacité auxiliaire 25, via la résistance 57.

Ainsi, lorsque le commutateur électronique 51 est dans le second état passant, on crée avantageusement un circuit auxiliaire d'alimentation comprenant le transistor JFET 15, la capacité auxiliaire 25, le commutateur électronique 51 et la résistance 57. On force alors la grille G du transistor JFET 15 à un potentiel négatif déterminé par la tension V_{R} aux bornes de la capacité auxiliaire 25, en court-circuitant la sortie 39 du circuit de commande de grille 30. Comme le commutateur électronique 51 est un transistor MOSFET générant très peu de courant de fuite à l'état passant, cette solution permet également de minimiser les pertes du circuit auxiliaire, et donc d'obtenir une durée T très importante et/ou une taille de la capacité auxiliaire 25 plus faible. En l'absence d'alimentation, le commutateur électronique 51 reste dans le second état passant.

Cependant, si le circuit de commande de grille 30 est en position haute (sortie 39 égale à Vs) lorsque le commutateur électronique 51 est à l'état passant, il faut forcer la sortie 39 à 0, pour éviter de faire passer un courant entre la sortie 39, la résistance 57 et la capacité auxiliaire 25. C'est pourquoi, le circuit auxiliaire de commande 50 comprend également un autre transistor bipolaire 53 dont le Collecteur est relié à l'entrée D_{IS} du circuit de commande de grille 30, dont l'Emetteur est relié à la borne négative de la capacité auxiliaire 25 et dont la Base est reliée à la base du transistor 54 via une résistance.

En fonctionnement normal, lorsque la tension Vs est présente, la diode Zener 55 conduit, donc le transistor 53 est passant et l'entrée D_{IS} du circuit de commande de grille 30 est égale à 0. Dès que la diode Zener 55 ne conduit plus, le transistor bipolaire 53 devient bloquant, ce qui force l'entrée D_{IS} du circuit de commande de grille 30 à l'état 1 de façon à supprimer la tension sur la sortie 39.

La figure 7 donne un deuxième exemple du circuit auxiliaire de commande 50. Dans ce deuxième exemple, on traite également la fonction de détection de court-circuit du transistor JFET 15. Pour cela, le dispositif de commande comprend un module de détection de court-circuit 35 déjà décrit précédemment.

Le circuit auxiliaire de commande 50 comporte en plus un transistor bipolaire 58 dont le Collecteur est relié à la Base du transistor 54, dont l'Emetteur est relié à la borne négative de la capacité auxiliaire 25 et dont la Base est reliée à la sortie 36 du module 35. Cette sortie 36 est envoyée également sur une porte logique OU pour être combinée avec le Collecteur du transistor 53. Ainsi, lorsque le module 35 détecte un court-circuit, sa sortie 36 passe à l'état 1, ce qui rend le transistor 58 passant et le transistor 54 devient bloquant. Dans ce cas, le commutateur électronique 51 bascule dans le second état passant, et la grille G du transistor JFET 15 est directement reliée à la borne négative de la capacité auxiliaire 25, via la résistance 57. Ainsi, on force une tension négative entre la grille G et la source S du transistor JFET 15 quand un court-circuit du transistor JFET 15 est détecté.

Selon une autre variante du second mode de réalisation représentée en figure 8, qui s'apparente à la variante de la figure 5, l'organe de commutation électronique comporte également un second commutateur électronique 52 de type transistor MOSFET à canal P, agencé entre la borne positive 28 et la diode 26 de façon à déconnecter la source auxiliaire d'énergie 25 de la source principale d'énergie lorsque le premier commutateur électronique 51 est positionné dans le second état passant. Le fonctionnement est le suivant :
- En fonctionnement normal, le transistor 54 est passant, et le premier commutateur 51 est à l'état bloqué ou non-passant. Donc le transistor 57 est également à l'état bloqué et le transistor 59 est passant. Dans ce cas, le second commutateur électronique 52 est à l'état passant et les bornes positives des capacités 21 et 25 sont reliées via la diode 26.
- Par contre, en cas de défaut (par exemple via la diode Zener 55 ou le transistor 58), le transistor 54 devient bloquant ce qui fait que le premier commutateur 51 est à l'état passant, car le Collecteur du transistor 54 est rappelé à 1. Le transistor 57 devient également passant et le transistor 59 passe à l'état bloqué. Donc, le second commutateur électronique 52 passe alors également à l'état bloqué, ce qui permet d'isoler la borne positive 28 de la diode 26, et ainsi de déconnecter la source auxiliaire d'énergie avec la source principale d'énergie. On s'affranchit ainsi des éventuels courants de fuite de la diode 26 lorsqu'elle est bloquée, ce qui rallonge d'autant la durée T pendant laquelle la capacité auxiliaire 25 peut maintenir le transistor JFET 15 à l'état OFF.

Il est bien entendu que l'on peut, sans sortir du cadre de l'invention, imaginer d'autres variantes et perfectionnements de détail et de même envisager l'emploi de moyens équivalents.

## Revendications

1. Dispositif de commande d'un interrupteur électronique de puissance JFET (15) de type normalement fermé, le dispositif de commande comprenant :
- un circuit principal de commande de grille (30) alimenté par une source principale d'énergie (11) pour piloter la grille (G) de l'interrupteur JFET (15),
- un organe de commutation de protection (41,51) qui est commutable entre une première position et une seconde position,
- une source auxiliaire d'énergie (25) qui est alimentée par ladite source principale d'énergie et dont la borne positive est connectée à la source (S) de l'interrupteur JFET (15),
**caractérisé en ce qu'**il comporte un circuit auxiliaire de commande (40,50) pilotant l'organe de commutation de protection (41,51), et **en ce que**, en l'absence de signal de commande venant du circuit auxiliaire de commande (40,50), l'organe de commutation de protection (41,51) est maintenu dans la seconde position dans laquelle la grille (G) de l'interrupteur JFET (15) est reliée à la borne négative de la source auxiliaire d'énergie (25) sans passer par ledit circuit principal de commande de grille (30).

2. Dispositif de commande selon la revendication 1, **caractérisé en ce que** l'interrupteur électronique de puissance JFET (15) est réalisé en carbure de silicium.

3. Dispositif de commande selon la revendication 1, **caractérisé en ce que** la source auxiliaire d'énergie est une capacité auxiliaire (25) connectée à la source principale d'énergie à travers une diode de charge (26).

4. Dispositif de commande selon la revendication 1, **caractérisé en ce que** l'organe de commutation de protection comporte un commutateur électromagnétique doté d'un contact mobile (41) entre deux positions sous l'action d'une bobine de commande (43) du circuit auxiliaire de commande (40), ledit contact mobile (41) étant commutable entre une première position dans laquelle la grille (G) de l'interrupteur JFET (15) est reliée au circuit principal de commande de grille (30) et une seconde position dans laquelle la grille (G) de l'interrupteur JFET (15) est reliée à la borne négative de la source auxiliaire d'énergie (25).

5. Dispositif de commande selon la revendication 4, **caractérisé en ce que** le circuit auxiliaire de commande (40) comprend un organe de détection d'un seuil minimum de tension (45) de la source principale d'énergie, au-dessous duquel la bobine de commande (43) du commutateur électromagnétique n'est pas alimentée.

6. Dispositif de, commande selon la revendication 5, **caractérisé en ce qu'**il comprend également un organe de détection (35) d'un court-circuit de l'interrupteur JFET (15).

7. Dispositif de commande selon la revendication 5 ou 6, **caractérisé en ce que** le commutateur électromagnétique comprend en plus un deuxième contact mobile (42) entre lesdites deux positions sous l'action de ladite bobine de commande (43), le deuxième contact mobile (42) étant agencé de façon à ce que la source auxiliaire d'énergie (25) soit déconnectée de la source principale d'énergie dans la seconde position.

8. Dispositif de commande selon l'une des revendications 4 à 7, **caractérisé en ce que** le commutateur électromagnétique est un commutateur de type MEMS.

9. Dispositif de commande selon la revendication 1, **caractérisé en ce que** l'organe de commutation de protection comprend un premier commutateur électronique (51) qui est placé entre la grille (G) de l'interrupteur JFET (15) et la borne négative de la source auxiliaire d'énergie (25), et qui est piloté par le circuit auxiliaire de commande (50) entre un premier état non-passant dans lequel la grille (G) de l'interrupteur JFET (15) n'est pas reliée à la borne négative de la source auxiliaire d'énergie (25) et un second état passant dans lequel la grille (G) de l'interrupteur JFET (15) est reliée à la borne négative de la source auxiliaire d'énergie (25).

10. Dispositif de commande selon la revendication 9, **caractérisé en ce que** le circuit auxiliaire de commande (50) comprend un organe de détection (55) d'un seuil minimum de tension de la source principale d'énergie, au-dessous duquel le circuit auxiliaire de commande (50) ne génère pas le signal de commande du premier commutateur électronique (51).

11. Dispositif de commande selon la revendication 10, **caractérisé en ce qu'**il comprend également un organe de détection (35) d'un court-circuit de l'interrupteur JFET (15).

12. Dispositif de commande selon l'une des revendications 8 à 11, **caractérisé en ce que** le premier commutateur électronique (51) est un transistor MOSFET.

13. Dispositif de commande selon la revendication 12, **caractérisé en ce que** l'organe de commutation comprend un second commutateur électronique (52) de type transistor MOSFET, agencé de façon à déconnecter la source auxiliaire d'énergie (25) de la source principale d'énergie lorsque le premier commutateur électronique (51) est positionné dans le second état passant.

14. Variateur de vitesse comprenant un étage onduleur (O) doté de plusieurs interrupteurs électroniques de puissance JFET (15a, 15b) de type normalement fermé pour fournir une tension variable à une charge électrique (M), telle qu'un moteur électrique, **caractérisé en ce que** le variateur comporte un dispositif de commande selon l'une des revendications précédentes pour chacun desdits interrupteurs électroniques de puissance.

## Claims

1. Control device for a JFET electronic power switch (15) of the normally closed type, the control device comprising:
- a gate control main circuit (30) powered by a main energy source (11) to drive the gate (G) of the JFET switch (15),
- a protection switching member (41, 51) which can be switched between a first position and a second position,
- an auxiliary energy source (25) which is powered by said main energy source and the positive terminal of which is connected to the source (S) of the JFET switch (15),
**characterized in that** it comprises an auxiliary control circuit (40, 50) driving the protection switching member (41, 51), and **in that**, in the absence of control signal from the auxiliary control circuit (40, 50), the protection switching member (41, 51) is maintained in the second position in which the gate (G) of the JFET switch (15) is linked to the negative terminal of the auxiliary energy source (25) without involving said gate control main circuit (30).

2. Control device according to Claim 1, **characterized in that** the JFET electronic power switch (15) is made of silicon carbide.

3. Control device according to Claim 1, **characterized in that** the auxiliary energy source is an auxiliary capacitor (25) connected to the main energy source through a charging diode (26).

4. Control device according to Claim 1, **characterized in that** the protection switching member comprises an electromagnetic switch provided with a contact (41) that moves between two positions under the action of a control coil (43) of the auxiliary control circuit (40), said moving contact (41) being switchable between a first position in which the gate (G) of the JFET switch (15) is linked to the gate control main circuit (30) and a second position in which the gate (G) of the JFET switch (15) is linked to the negative terminal of the auxiliary energy source (25).

5. Control device according to Claim 4, **characterized in that** the auxiliary control circuit (40) comprises a member for detecting a minimum voltage threshold (45) of the main energy source, below which the control coil (43) of the electromagnetic switch is not powered.

6. Control device according to Claim 5, **characterized in that** it also comprises a member (35) for detecting a short circuit of the JFET switch (15).

7. Control device according to Claim 5 or 6, **characterized in that** the electromagnetic switch also comprises a second contact (42) that moves between said two positions under the action of said control coil (43), the second moving contact (42) being arranged so that the auxiliary energy source (25) is disconnected from the main energy source in the second position.

8. Control device according to one of Claims 4 to 7, **characterized in that** the electromagnetic switch is an MEMS-type switch.

9. Control device according to Claim 1, **characterized in that** the protection switching member comprises a first electronic switch (51) which is placed between the gate (G) of the JFET switch (15) and the negative terminal of the auxiliary energy source (25), and which is driven by the auxiliary control circuit (50) between a non-passing first state in which the gate (G) of the JFET switch (15) is not linked to the negative terminal of the auxiliary energy source (25) and a passing second state in which the gate (G) of the JFET switch (15) is linked to the negative terminal of the auxiliary energy source (25).

10. Control device according to Claim 9, **characterized in that** the auxiliary control circuit (50) comprises a member (55) for detecting a minimum voltage threshold of the main energy source, below which the auxiliary control circuit (50) does not generate the control signal of the first electronic switch (51).

11. Control device according to Claim 10, **characterized in that** it also comprises a member (35) for detecting a short circuit of the JFET switch (15).

12. Control device according to one of Claims 8 to 11, **characterized in that** the first electronic switch (51) is a MOSFET transistor.

13. Control device according to Claim 12, **characterized in that** the switching member comprises a second electronic switch (52) of MOSFET transistor type, arranged so as to disconnect the auxiliary energy source (25) from the main energy source when the first electronic switch (51) is in the passing second state.

14. Variable speed drive comprising an inverter stage (O) provided with a number of JFET electronic power switches (15a, 15b) of normally-closed type for supplying a variable voltage to an electrical load (M), such as an electric engine, **characterized in that** the variable speed drive comprises a control device according to one of the preceding claims for each of said electronic power switches.

## Patentansprüche

1. Vorrichtung zur Steuerung eines elektronischen JFET-Leistungsschalters (15) vom normalerweise geschlossenen Typ, wobei die Steuervorrichtung enthält:
- einen Gate-Hauptsteuerkreis (30), der von einer Hauptenergiequelle (11) gespeist wird, um das Gate (G) des JFET-Schalters (15) zu steuern,
- ein Schutzumschaltorgan (41, 51) das zwischen einer ersten Stellung und einer zweiten Stellung umschaltbar ist,
- eine Hilfsenergiequelle (25), die von der Hauptenergiequelle gespeist wird und deren positive Klemme mit der Source (S) des JFET-Schalters (15) verbunden ist,
**dadurch gekennzeichnet, dass** sie einen Hilfssteuerkreis (40, 50) aufweist, der das Schutzumschaltorgan (41, 51) steuert, und dass in Abwesenheit eines vom Hilfssteuerkreis (40, 50) kommenden Steuersignals das Schutzumschaltorgan (41, 51) in der zweiten Stellung gehalten wird, in der das Gate (G) des JFET-Schalters (15) mit der negativen Klemme der Hilfsenergiequelle (25) verbunden ist, ohne über den Gate-Hauptsteuerkreis (30) zu gehen.

2. Steuervorrichtung nach Anspruch 1, **dadurch gekennzeichnet, dass** der elektronische JFET-Leistungsschalter (15) aus Siliciumcarbid hergestellt ist.

3. Steuervorrichtung nach Anspruch 1, **dadurch gekennzeichnet, dass** die Hilfsenergiequelle ein Hilfskondensator (25) ist, der über eine Lastdiode (26) mit der Hauptenergiequelle verbunden ist.

4. Steuervorrichtung nach Anspruch 1, **dadurch gekennzeichnet, dass** das Schutzumschaltorgan einen elektromagnetischen Umschalter aufweist, der mit einem unter der Wirkung einer Steuerspule (43) des Hilfssteuerkreises (40) zwischen zwei Stellungen beweglichen Kontakt (41) versehen ist, wobei der bewegliche Kontakt (41) zwischen einer ersten Stellung, in der das Gate (G) des JFET-Schalters (15) mit dem Gate-Hauptsteuerkreis (30) verbunden ist, und einer zweiten Stellung umgeschaltet werden kann, in der das Gate (G) des JFET-Schalters (15) mit der negativen Klemme der Hilfsenergiequelle (25) verbunden ist.

5. Steuervorrichtung nach Anspruch 4, **dadurch gekennzeichnet, dass** der Hilfssteuerkreis (40) ein Organ zur Erfassung einer Mindestspannungsschwelle (45) der Hauptenergiequelle enthält, unterhalb von der die Steuerspule (43) des elektromagnetischen Umschalters nicht gespeist wird.

6. Steuervorrichtung nach Anspruch 5, **dadurch gekennzeichnet, dass** sie ebenfalls ein Organ (35) zur Erfassung eines Kurzschlusses des JFET-Schalters (15) enthält.

7. Steuervorrichtung nach Anspruch 5 oder 6, **dadurch gekennzeichnet, dass** der elektromagnetische Umschalter außerdem einen zweiten unter der Wirkung der Steuerspule (43) zwischen den zwei Stellungen beweglichen Kontakt (42) enthält, wobei der zweite bewegliche Kontakt (42) so eingerichtet ist, dass die Hilfsenergiequelle (25) in der zweiten Stellung von der Hauptenergiequelle getrennt ist.

8. Steuervorrichtung nach einem der Ansprüche 4 bis 7, **dadurch gekennzeichnet, dass** der elektromagnetische Umschalter ein Umschalter vom Typ MEMS ist.

9. Steuervorrichtung nach Anspruch 1, **dadurch gekennzeichnet, dass** das Schutzumschaltorgan einen ersten elektronischen Umschalter (51) enthält, der zwischen dem Gate (G) des JFET-Schalters (15) und der negativen Klemme der Hilfsenergiequelle (25) angeordnet ist, und der vom Hilfssteuerkreis (50) zwischen einem ersten nicht-leitenden Zustand, in dem das Gate (G) des JFET-Schalters (15) nicht mit der negativen Klemme der Hilfsenergiequelle (25) verbunden ist, und einem zweiten leitenden Zustand gesteuert wird, in dem das Gate (G) des JFET-Schalters (15) mit der negativen Klemme der Hilfsenergiequelle (25) verbunden ist.

10. Steuervorrichtung nach Anspruch 9, **dadurch gekennzeichnet, dass** der Hilfssteuerkreis (50) ein Organ (55) zur Erfassung einer Mindestspannungsschwelle der Hauptenergiequelle enthält, unterhalb von der der Hilfssteuerkreis (50) nicht das Steuersignal des ersten elektronischen Umschalters (51) erzeugt.

11. Steuervorrichtung nach Anspruch 10, **dadurch gekennzeichnet, dass** sie ebenfalls ein Organ (35) zur Erfassung eines Kurzschlusses des JFET-Schalters (15) enthält.

12. Steuervorrichtung nach einem der Ansprüche 8 bis 11, **dadurch gekennzeichnet, dass** der erste elektronische Umschalter (51) ein MOSFET-Transistor ist.

13. Steuervorrichtung nach Anspruch 12, **dadurch gekennzeichnet, dass** das Umschaltorgan einen zweiten elektronischen Umschalter (52) vom Typ MOSFET-Transistor enthält, der eingerichtet ist, um die Hilfsenergiequelle (25) von der Hauptenergiequelle zu trennen, wenn der erste elektronische Umschalter (51) im zweiten leitenden Zustand positioniert ist.

14. Umrichter, der eine Wechselrichterstufe (O) enthält, die mit mehreren elektronischen JFET-Leistungsschaltern (15a, 15b) vom normalerweise geschlossenen Typ versehen ist, um an eine elektrische Last (M) wie einen Elektromotor eine variable Spannung zu liefern, **dadurch gekennzeichnet, dass** der Umrichter eine Steuervorrichtung nach einem der vorhergehenden Ansprüche für jeden der elektronischen Leistungsschalter aufweist.
